(19) Europäisches Patentamt
European Patent Office
Office européen des brevets

(11) EP 0 834 911 B1

# (12) EUROPEAN PATENT SPECIFICATION

(45) Date of publication and mention of the grant of the patent:
**16.01.2002 Bulletin 2002/03**

(51) Int Cl.[7]: **H01L 21/316**, H01L 23/28, H01L 21/48, H01L 23/498, C04B 41/50

(21) Application number: **97307505.4**

(22) Date of filing: **25.09.1997**

(54) **Opaque ceramic coatings**

Opake Keramikbeschichtung

Revêtement opaque de céramique

(84) Designated Contracting States:
**DE FR GB IT NL**

(30) Priority: **04.10.1996 US 725791**
**10.01.1997 US 780946**

(43) Date of publication of application:
**08.04.1998 Bulletin 1998/15**

(73) Proprietor: **DOW CORNING CORPORATION**
**Midland Michigan 48686-0994 (US)**

(72) Inventors:
- **Camiletti, Robert Charles**
  **Midland, Michigan 48640 (US)**
- **Haluska, Loren Andrew**
  **Midland, Michigan 48640 (US)**
- **Michael, Keith Winton**
  **Midland, Michigan 48640 (US)**

(74) Representative: **Kyle, Diana et al**
**Elkington and Fife Prospect House 8 Pembroke Road**
**Sevenoaks, Kent TN13 1XR (GB)**

(56) References cited:
**US-A- 3 986 997**
**US-A- 5 258 334**
**US-A- 5 399 441**
**US-A- 4 689 085**
**US-A- 5 369 299**
**US-A- 5 468 990**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

EP 0 834 911 B1

## Description

This invention is a method of forming coatings using compositions containing a methyl silsesquioxane resin, colloidal silica and/or certain other opaque materials and/or obstructing agents as coating for electronic devices.

The use of hydrogen silsesquioxane resin $(HSiO_{3/2})_n$ derived ceramic coatings on substrates such as electronic devices is known. U.S. Patent No. 4,756,977 discloses a process of forming a silica coating on an electronic substrate by applying to the substrate a solution of hydrogen silsesquioxane resin and thereafter heating the coated substrate in air at a temperature in the range of 200-1,000°C. However, it is not possible to produce thick planarizing coatings from hydrogen silsesquioxane resins. U.S. 4,756,977, however, does not teach the use of opaque materials or obstructing agents within the coating, nor is the $(HSiO_{3/2})_n$ resin derived ceramic coatings on the substrate taught to be resistant to wet etching techniques.

The use of hydrolyzed or partially hydrolyzed silicate esters derived ceramic coatings on substrates such as electronic devices is known. U.S. Patent No. 4,749,631 discloses a process for forming a silica coating on an electronic substrate by applying to the substrate a solution of a hydrolyzed or partially hydrolyzed silicate ester and thereafter heating the coated substrate at a temperature in the range of 200 to 1,000°C.

The use of an acidic dispersion of colloidal silica and partial condensate of $RSi(OH)_3$ to produce abrasion resistant coatings is known. U.S. Patent No. 3,986,997 to Clark describes a coating composition containing an acidic dispersion of colloidal silica and partial condensate of methylsilanetriol in an alcohol-water medium. The coating composition can be used to apply transparent abrasion resistant coatings on a variety of substrates. However, U.S. Patent 3,986,997 does not teach producing a ceramic or ceramic-like coating from the acidic dispersion or the use of the acidic dispersion to form planarizing coatings on electronic substrates. Nor does it describe the use of tungsten carbide, tungsten metal or phosphoric anhydride, as an opaque material or obstructing agent; it does not describe applying the coating on an electronic substrate for the purpose of providing resistance to wet etching.

Accordingly, what we have discovered is that useful coatings can be formed from compositions containing colloidal silica and partial condensate of methylsilanetriol and certain other additional opaque materials or obstructing agents; and that these coatings provide protection and resistance against various intrusion techniques, especially wet etching.

This invention pertains to a method of forming a coating on an electronic substrate and to the electronic substrates coated thereby. The method comprises applying on the electronic substrate a coating composition comprising an aqueous alkanol dispersion of colloidal silica and partial condensate of $RSi(OH)_3$ where R is selected from an alkyl radical having from 1 to 3 carbon atoms, the vinyl radical, the 3,3,3-trifluoropropyl radical, the gamma-glycidoxypropyl radical and the gamma-methacryloxypropyl radical with the provision that at least 70% of the R radicals are methyl and thereafter ceramifying the coating by heating at a temperature of 200 to 1000°C. The use of the coating composition comprising an aqueous alkanol dispersion of colloidal silica and partial condensate of $RSi(OH)_3$ allows for the formation of thick planarizing coatings on the electronic substrate.

This invention further relates to a method which comprises applying a coating composition containing an opaque material or obstructing agent carried in an aqueous alkanol dispersion of colloidal silica and partial condensate of methylsilanetriol on the substrate. The coated substrate is then heated at a temperature sufficient to convert (pyrolyze) the coating composition to a ceramic coating. The method is especially valuable for forming protective coatings on a variety of electronic devices.

This invention also relates to the coating composition containing an opaque material or obstructing agent carried in an aqueous alkanol dispersion of colloidal silica and partial condensate of methylsilanetriol.

The thick opaque protective ceramic coating is effective against various forms of energy and contains a solid reactive material that is a deterrent for preventing examination of an integrated circuit. The coating is effective against ozone, UV-ozone, gaseous free radicals and ions, any vapor or liquid borne reactive species or plasmas. In addition, the coating is resistant to abrasion and is opaque to radiation and light.

The coating contains a combination of colloidal silica and partial condensate of methylsilanetriol, which is more resistant to being wet chemical etched with either an acid or a base, because it presents a surface that is more hydrophobic than a hydrogen silsesquioxane resin. This enhances the tamper-proof qualities of the coating. The coating may contain solid $P_2O_5$ which further obstructs and acts as a deterrent to any attack by wet etching techniques. It functions in this capacity by generating phosphoric acid that would readily destroy the integrated circuit and its memory.

One embodiment of the coating is prepared from a combination of colloidal silica and partial condensate of methylsilanetriol, tungsten carbide (WC), tungsten metal (W) and solid $P_2O_5$. These components of the coating composition provide protection for any microelectronic device and are useful for application on gallium arsenide (GaAs), silicon, metallic or other electronic substrates, devices or patterned wafers. If desired, a second hermetic coating, such as PECVD silicon carbide, diamond or silicon nitride, can be applied to provide hermeticity.

By "electronic substrate", it is meant to include silicon based devices and gallium arsenide based devices intended for use in the manufacture of a semiconductor component including focal plane arrays, opto-electronic devices, photovoltaic cells, optical devices, transistor-like devices, 3-D devices, silicon-on-insulator devices and super lattice devices. Electronic substrates include wafers resulting from the fabrication of integrated circuits and semiconductor devices. Typically, the devices are completely fabricated up to the point of the interconnect system, usually bond pads, while still in the wafer stage. It is desirable and economical to apply these coatings to the electronic devices while they are still in the wafer stage as an electronic substrate. Such coated devices are then separated from each other and continued into the packaging and assembly stages. Alternately, the electronic substrates can be the actual separated semiconductor devices or integrated circuit devices, before or after the interconnects are made to an electronic assembly.

A ceramic coating is formed on a substrate by applying a coating composition comprising an aqueous alkanol dispersion of colloidal silica and partial condensate of $RSi(OH)_3$ onto the substrate and then heating and pyrolyzing the coated substrate at a temperature sufficient to convert the coating composition to a ceramic coating.

As used herein, the expression "ceramic coating" is intended to describe a hard coating obtained after heating or pyrolyzing the coating composition. The ceramic coating may contain both amorphous silica ($SiO_2$) materials, as well as amorphous silica-like materials that are not fully free of residual carbon and silanol (≡SiOH) and/or hydrogen, which are obtained upon heating the coating composition.

Aqueous alkanol dispersions of colloidal silica and partial condensate of $RSi(OH)_3$ where R is as described above are known in the art and are described in U.S. Patent 3,986,997 which specifically teaches a coating composition comprising a dispersion containing colloidal silica and a partial condensate of methylsilanetriol.

The silica component of the coating composition of the present invention is present as an aqueous colloidal silica dispersion having a particle diameter of 5-150 nanometers. The partial condensate component of the coating composition is predominately derived from methylsilanetriol, but may contain other silanols of the formula $RSi(OH)_3$ in which R is an alkyl radical of 2 or 3 carbon atoms; the vinyl radical ($CH_2$=CH-); the 3,3,3-trifluoropropyl radical ($CF_3CH_2CH_2$-); the 3-glycidoxypropyl radical or the 3-methacryloxypropyl radical ($CH_2=C(CH_3)COOCH_2CH_2CH_2$-). At least 70 weight percent of the silanol is $CH_3Si(OH)_3$.

Preferably, the aqueous alkanol dispersion of colloidal silica and partial condensate of $RSi(OH)_3$ contains 10-50 weight percent solids, with the distribution being 10-70 weight percent colloidal silica and 30-90 weight percent of the partial condensate. The partial condensate component is carried in a lower aliphatic alcohol-water solvent, i.e., methanol, ethanol, isopropanol, n-butyl alcohol or mixtures thereof.

The aqueous alkanol dispersions of colloidal silica and partial condensate of $RSi(OH)_3$ where R is as described above, is prepared by adding a trialkoxysilane $RSi(OCH_3)_3$ to a colloidal silica hydrosol and adjusting the pH to 3-6 with an organic acid such as acetic acid. Trisilanols are generated in situ by adding the trialkoxysilane to the acidic aqueous dispersion of colloidal silica. Upon generation of the silanol in the acidic aqueous medium, there occurs a partial condensation of hydroxyl substituents to form ≡Si-O-Si≡ bonding. Alcohol is also generated by hydrolysis of the alkoxy substituents of the silane. Depending upon the percent solids desired, additional alcohol, water or water-miscible solvent can be added, to adjust the level of solids in the coating composition. This coating composition is a clear or slightly hazy low viscosity fluid which is stable for several days, but condensation of ≡SiOH will continue at a very slow rate and the coating composition eventually forms a gel structure.

Our coating composition may also contains other opaque materials or obstructing agents, in addition to tungsten, tungsten carbide and $P_2O_5$. For purposes herein, the terms opaque material or obstructing agent are used synonymously to describe a finely divided solid phase, which is distributed within the resin and the final ceramic coating and which tends to (i) obstruct inspection, (ii) hinder inspection or (iii) prevent reverse engineering of the device.

Specific materials useful in the instant invention include, but are not limited to, optically opaque materials, radiopaque materials, luminescent materials, oxidizing materials, abrasion resistant materials, magnetic materials and conductive materials. Various inorganic and organic types of materials can be used in a variety of morphologies, including, but not limited to, powders, particles, flakes and microballoons.

Optically opaque materials are agents that when mixed with the preceramic silicon-containing material, render the resulting coating impenetrable to visual light. Optically opaque materials include, but are not limited to, oxides, nitrides and carbides of silicon, alumina, metals and inorganic pigments. Some preferred optically opaque materials are plasma alumina microballoons having an average particle size of 6 μm, silica microballoons having an average particle size of 5-40 μm, silicon nitride ($Si_3N_4$) powder or whiskers; silicon carbide (SiC) powder or whiskers, aluminum nitride (AlN) powder and black inorganic pigments such as black Ferro® F6331 having an average particle size of 0.4 μm.

Radiopaque materials are agents that when mixed with the preceramic silicon-containing material, render the resulting coating impenetrable to radiation, such as x-rays, UV, IR and visible light, as well as sound waves. Radiopaque materials include but are not limited to heavy metals such as lead and insoluble salts of heavy metals such as barium, lead, silver, gold, cadmium, antimony, tin, palladium, strontium and bismuth. The salts can include for example, carbonates, sulfates and oxides.

Luminescent materials are agents that when mixed with the preceramic silicon-containing material, result in

a coating that will absorb energy and emit electromagnetic radiation in excess of thermal radiation. These materials are typically phosphors such as sulfides (i.e., zinc sulfide and cadmium sulfide); selenides; sulfoselenides; oxysulfides; oxygen dominate phosphors such as borates, aluminates, gallates and silicates; and halide phosphors such as alkali metal halides, alkaline earth halides and oxyhalides. Preferred are sulfides and most preferred is zinc sulfide. The phosphor compound may be doped with an activator. Activators include, but are not limited to, manganese, silver, copper and rare earth ions in the form of halides. The activator is generally present in amounts of 0.1-10 mol percent based on the weight of the phosphor.

Abrasion resistant materials are agents that when mixed with the preceramic silicon-containing material, render the resulting coating impenetrable to removal by frictional means such as scraping. Abrasion resistant materials are exemplified by, but not limited to diamond, diamond dust, titanium nitride (TiN), tantalum carbide (TaC) and fibers of graphite, KEVLAR® (a DuPont trademark for aromatic polyamide fibers), NEXTEL (a tradename of the 3M Company for boria-modified alumina-silica fibers) and aluminum oxide ($Al_2O_3$).

Energy resistant materials are agents that when mixed with the preceramic silicon-containing material, react with energy sources such as ozone, UV-ozone, gaseous free radicals and ions, any vapor or liquid borne reactive species and plasmas, to effectively cause degradation of the circuit and the memory. Energy resistant materials are exemplified by, but not limited to heavy metals such as lead, tungsten, tantalum and antimony.

Magnetic materials are agents that when mixed with the perceramic silicon-containing material, render the resulting coating magnetic (i.e., magnetized by a magnetic field having a net magnetic moment). Magnetic materials are exemplified by carbon alloy ferrites, iron carbonyl and alloys of metals such as iron, manganese, cobalt, nickel, copper, titanium, vanadium, molybdenum, magnesium, aluminum, chromium, zirconium, lead and zinc. Some specific agents are $Fe_2O_3$, MnZn, NiZn and CuZn.

Conductive materials are agents that when mixed with the perceramic silicon-containing material, render the resulting coating either electrically or thermally conductive. Conductive materials are exemplified by gold, silver, copper, aluminum, nickel, zinc, chromium, cobalt and diamond.

Other opaque materials or obstructing agents useful herein include synthetic and natural materials such as oxides, nitrides, borides and carbides of various metals and non-metals such as glass, phosphorus oxynitride (PON), alumina, titanium dioxide, zinc oxide, zirconium oxide ($ZrO_2$) and ruthenium oxide ($RuO_2$); titanates such as potassium titanate and barium titanate; niobates such as lithium niobate ($LiNbO_3$) and lead niobate $Pb(NbO_3)_2$; barium sulfate; calcium carbonate; precipitated diatomite; aluminum silicate or other silicates; pigments and dyes such as crystal violet ($C_{25}H_{30}N_3Cl$) and the cyanines; phosphors; metals such as silver, aluminum or copper; wollastonite ($CaSiO_3$); mica; kaolin; clay; talc; organic materials such as cellulose, polyimides, phenol resins, epoxies, polybenzocyclobutanes; fluorocarbon polymers such as polytetrafluoroethylene $(C_2F_4)_n$, vinylidene fluoride $H_2C{=}CF_2$ and hexafluoropropylene $CF_3CF{:}CF_2$; high dielectric constant materials such as titanate, niobate or tungstate salts of metals such as strontium, zirconium, barium, lead, lanthanium, iron, zinc and magnesium, i.e., barium titanate ($BaTiO_3$), potassium titanate ($K_2TiO_3$), lead niobate, lithium titanate, strontium titanate, barium strontium titanate, lead lanthanium zirconium titanate, lead zirconium titanate and lead tungstate.

The type of opaque material or obstructing agent employed will depend on the intended use of the coating. Thus, if the coating is to be used as an interlayer dielectric, a material such as alumina is desirable, so that the coating will have a low dielectric constant (DK). If a coating having a high DK is desired, a material such as barium titanate or lead niobate should be employed. If a conductive coating is desired, other types of metals can be added.

The particle size and shape of the opaque material or obstructing agent can vary over a wide range, depending on factors such as type of material and desired thickness of the coating. Our coatings are preferably less than 500 micrometers in thickness, so a particle size of 100 to less than 500 micrometers is generally sufficient. A smaller particle size can be used, such as 50-100 µm or even particle size from submicrometer (i.e., 5-150 nm) to 10 µm.

The amount of opaque material or obstructing agent can be varied, depending on quality and electrical characteristics desired in the final coating. Generally, the opaque material or obstructing agent is used in amounts of from one weight percent to less than 94 weight percent, based on the weight of colloidal silica and partial condensate of methylsilanetriol. Sufficient resin must be employed to insure that enough resin is present to bind the opaque material or obstructing agent. Lesser amounts of opaque material or obstructing agent can also be employed, i.e., 1-5 weight percent.

If desired, the coating composition can contain a silane coupling agent to modify the surface of the opaque material or obstructing agent for better adhesion. Generally, silane coupling agents conform to the formula $A_{(4-n)}SiY_n$ where A is a monovalent organic radical such as an alkyl group, an aryl group or a functional group such as methacryl, methacryloxy, epoxy, vinyl or allyl; Y is a hydrolyzable radical such as an alkoxy group with 1-6 carbon atoms, an alkoxyalkoxy group with 2-8 carbon atoms or an acetoxy group; and n is 1, 2 or 3, preferably 3.

Some examples of suitable silane coupling agents are 3-methacryloxypropyltrimethoxysilane of the formula $CH_2{=}C(CH_3)COO(CH_2)_3Si(OCH_3)_3$; 3-glycidoxypropyltrimethoxysilane; 3-mercaptopropyltrimethoxysilane of the formula $HSCH_2CH_2CH_2Si(OCH_3)_3$; vinyltriacetoxysilane of the formula $CH_2{=}CHSi(OOCCH_3)_3$; vinyltriethoxysilane of the

formula $CH_2=CHSi(OC_2H_5)_3$; vinyl-tris(2-methoxyethoxy)silane of the formula $CH_2=CHSi(OCH_2CH_2OCH_3)_3$; and 2-(3,4-epoxycyclohexyl)-ethyltrimethoxysilane. U.S. Patent 4,689,085 describes these and other suitable silane coupling agents that are appropriate.

According to our process, the coating composition is applied to the surface of a substrate such as an electronic device. Various facilitating measures such as stirring and heating may be used to dissolve or disperse the opaque material or obstructing agent in the base coating composition and create a more uniform coating solution. For example, the coating solution can be prepared by mixing the resin, opaque material or obstructing agent, solvent and silane coupling agent, with a homogenizer, sonic probe or colloid mill, to obtain a coating solution suitable for application to the surface of an electronic device.

Solvents which may be used include any agent or mixture of agents which will dissolve or disperse the resin and opaque material, to form a homogenous liquid mixture without affecting the resultant coating. These solvents can include, for example, alcohols such as ethyl alcohol, isopropyl alcohol and n-butanol; ketones; esters; and glycol ethers. The solvent should be present in an amount sufficient to dissolve or disperse the materials to the concentration desired for the application. Generally, enough solvent is used to form a 0.1-80 weight percent mixture, but preferably a 1-50 weight percent mixture.

The coating composition may optionally contain other ceramic oxide precursors, examples of which are compounds of various metals such as aluminum, titanium, zirconium, tantalum, niobium or vanadium; and non-metallic compounds such as boron or phosphorus; any of which may be dissolved in solution, hydrolyzed and subsequently pyrolyzed to form ceramic oxide coatings.

These ceramic oxide precursor compounds generally have one or more hydrolyzable groups bonded to the metal or non-metal depending on the valence of the metal. The number of hydrolyzable groups included in such compounds is not critical provided the compound is soluble in the solvent. Likewise, selection of an exact hydrolyzable substituent is not critical since it will be either hydrolyzed or pyrolyzed out of the system.

Typical hydrolyzable substituents include alkoxy groups such as methoxy, propoxy, butoxy and hexoxy; acyloxy groups such as acetoxy; and other organic groups bonded to the metal or non-metal through an oxygen atom such as acetylacetonate. Some specific compounds that can be used are zirconium tetracetylacetonate, titanium dibutoxy diacetylacetonate, aluminum triacetylacetonate and tetraisobutoxy titanium.

When the coating composition is combined with one of these ceramic oxide precursors, generally it is used in an amount such that the final ceramic coating contains 0.1-30 percent by weight of the modifying ceramic oxide precursor.

The coating composition may contain a platinum, rhodium or copper catalyst, to increase the rate and extent of conversion of the precursors to silica. Generally, any platinum, rhodium or copper compound or complex which can be solubilized is appropriate, such as platinum acetylacetonate, rhodium catalyst $RhCl_3[S(CH_2CH_2CH_2CH_3)_2]_3$ (a product of Dow Corning Corporation, Midland, Michigan) or cupric naphthenate. These catalysts can be added in amounts of 5 to 1,000 parts per million of platinum, rhodium or copper, based on the weight of the coating composition.

The coating composition is then coated onto the substrate. The coating composition can be applied by spin coating, dip coating, spray coating or flow coating. Any other equivalent coating method can also be employed such as by applying the coating composition on a substrate or device by silk screening, screen printing, meniscus coating or wave solder coating.

The solvent is allowed to evaporate from the coated substrate resulting in deposition of the coating. Any means of evaporation may be used such as air drying by exposure to an ambient environment or by application of vacuum or mild heat (i.e., less than 50°C) during early stages of the heat treatment. When spin coating is used, any additional drying period is minimized as spinning drives off the solvent to some extent.

Following removal of solvent, the coating composition is converted to a ceramic coating by pyrolysis, i.e., heating it to a sufficient temperature to ceramify. Generally, this temperature is in the range of 200 to 1,000°C depending on the pyrolysis atmosphere. Preferred temperatures are in the range of 200 to 800°C when an opaque material is not present. Preferred temperatures are in the range of 400 to 800°C when the coating composition contains an opaque material. Heating is conducted for a time sufficient to ceramify the coating composition. Generally, heating will require one to 6 hours, but typically less than 3 hours will be adequate.

Heating to ceramify the coating composition may be conducted at atmospheric pressures varying from vacuum to superatmospheric and under an oxidizing or non-oxidizing gaseous environment such as air, oxygen, an inert gas such as nitrogen, ammonia, an amine, moisture or nitrous oxide. Heating can be carried out using a convection oven, a rapid thermal process, a hot plate, radiant energy or microwave energy. The rate of heating is not critical although it is practical to heat the coating composition as rapidly as possible.

Pyrolysis results in removal of organic substituents and their replacement by oxygen. By this method, a ceramic coating is produced on the substrate, generally according to the scenario:

$$CH_3SiO_{3/2} \xrightarrow[\blacktriangle]{O_2} SiO_2 + CO_2 + H_2O$$

What differentiates this invention from that described in U.S. Patent No. 3,986,997 is that in this invention the methyl groups on $CH_3SiO_{3/2}$ are oxidized to form $SiO_2$. The oxidation may not be complete due to the thickness of the coating composition, so that some methyl groups on silicon will remain. In U.S. 3,986,997, by contrast, all of the methyl groups remain on silicon and curing of the resin occurs through a condensation of the silanol and methoxy groups at temperatures in the range of 50-150°C. Therefore, U.S. 3,986,997 employs a condensation cure, while in this invention, we utilize oxidation and thermal rearrangement, although some condensation may occur during the period of heating.

The thickness of the ceramic coating can vary over a wide range, but is typically from 1-500 micrometers. These ceramic coatings are able to smooth irregular surfaces of various substrates. The coatings are (i) relatively defect free, (ii) have excellent adhesive properties, and (iii) have a variety of electrical properties, i.e., DK's less than four and up to conductive coatings. As such, such coatings are particularly useful for electronic applications such as dielectric layers, protective layers and conductive layers.

If desired, additional coatings may be applied over the ceramic coating. These additional coatings include $SiO_2$ coatings, $SiO_2$/ceramic oxide layers, silicon-containing coatings, silicon carbon containing coatings, silicon nitrogen containing coatings, silicon oxygen nitrogen containing coatings, silicon nitrogen carbon containing coatings and diamond-like carbon coatings. Methods for applying such coatings are described in US 4,756,977. An especially preferred additional coating is silicon carbide.

The method of applying an additional coating such as silicon carbide is not critical and such coatings can be applied by any chemical vapor deposition technique such as thermal chemical vapor deposition (TCVD), photochemical vapor deposition, plasma enhanced chemical vapor deposition (PECVD), electron cyclotron resonance (ECR) and jet vapor deposition. It could also be applied by physical vapor deposition techniques such as sputtering or electron beam evaporation. These processes involve either the addition of energy in the form of heat or plasma to a vaporized species to cause the desired reaction or they focus energy on a solid sample of the material to cause its deposition.

For example, in thermal CVD, the coating is deposited by passing a stream of the desired precursor gas over a heated substrate. When the precursor gas contacts the hot surface, it reacts and deposits the coating. Substrate temperatures in the range of 25 to 1,000°C are sufficient to form these coatings in several minutes to several hours, depending on the precursor gas and the thickness of the coating. Reactive metals can be used in such a process to facilitate deposition.

In PECVD techniques, a precursor gas is reacted by passing it through a plasma field. Reactive species are formed and focused at the substrate where they readily adhere. The advantage of a PECVD process over a thermal CVD process is that in the former, lower substrate and processing temperatures can be used, i.e., 25 to 600°C.

Plasma used in a PECVD process can be energy derived from electric discharges, electromagnetic fields in the radio-frequency or microwave range, lasers or particle beams. In most plasma deposition processes, it is preferred to use radio frequency (i.e., 10 kHz to $10^2$ MHz) or microwave energy (i.e., 0.1-10 GHz or $10^9$ hertz) at moderate power densities (i.e., 0.1-5 watts/$cm^2$). The frequency, power and pressure are tailored to the precursor gas and equipment being used.

Some precursor gases that can be used include (1) mixtures of silanes or halosilanes such as trichlorosilane ($HSiCl_3$) in the presence of an alkane of 1-6 carbon atoms such as methane, ethane and propane; (2) an alkylsilane such as methylsilane ($CH_3SiH_3$), dimethylsilane $(CH_3)_2SiH_2$, trimethylsilane $(CH_3)_3SiH$ and hexamethyldisilane $(CH_3)_3Si\text{-}Si(CH_3)_3$; or (3) a silacyclobutane or a disilacyclobutane of the type described in U.S. Patent No. 5,011,706.

Examples of such silacyclobutanes (1) and disilacyclobutanes (2) are shown below. R1 is hydrogen, fluorine or a hydrocarbon radical having 1-4 carbon atoms. R2 is hydrogen or a hydrocarbon radical having 1-4 carbon atoms. A preferred disilacyclobutane is 1,3-dimethyl-1,3-disilacyclobutane shown in formula (3).

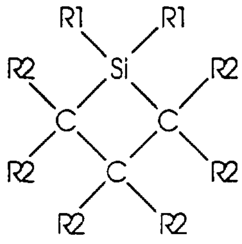 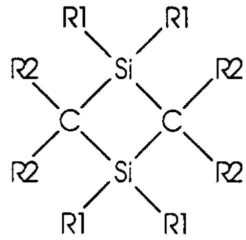 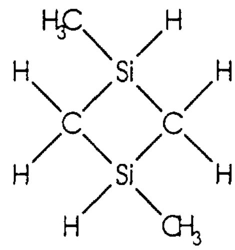

(1) (2) (3)

When silicon carbide is used as a coating layer, it is capable of forming a hermetic and electrical barrier over the surface of the silica-containing ceramic layer on the electronic device and inhibits damage from chemical and mechanical means.

In a preferred coating composition according to our invention, the matrix resin is colloidal silica and partial condensate of methylsilanetriol. Opaque material or obstructing agents for the coating composition are tungsten carbide, tungsten, $P_2O_5$ and mixtures thereof. Tungsten metal is the material that functions as an energy barrier. Tungsten metal and tungsten carbide are each effective against radiation and light. Tungsten carbide has a MoHs' hardness rating greater than 9.5 and tungsten metal has a MoHs' hardness of 6.5-7.5. Tungsten carbide is therefore the more effective against abrasion, although each are included in the coating composition and function to provide abrasion resistance.

MoHs' hardness, it is noted, is a comparison test involving the assignment of a relative number to known materials based on their ability to scratch one another. Some examples of the MoHs' hardness scale which ranks materials from 1-10, are graphite with a MoHs' hardness of 1, manganese with a MoHs' hardness of 5, quartz with a MoHs' hardness of 7 and diamond with a MoHs' hardness of 10.

As noted previously, $P_2O_5$ protects the integrated circuit and its memory from invasion by wet etching techniques and the silane coupling agent can be included in the coating composition to improve adhesion of the coating to the electronic device.

The following examples are presented to illustrate the present invention. These examples are not intended to limit the scope of this invention found in the claims.

## EXAMPLE 1

A 10 cm (4") silicon wafer was spin coated at 1500 RPM for 20 seconds with Silvue® 101 (SDC Coatings, Inc., Anaheim, CA.; 31 wt% solids of 40% $SiO_2$ and 60% partial condensate of $CH_3Si(OH)_3$ in methanol and isopropanol). Two coats of the resin solution were applied to the wafer, then the coated wafer was pyrolyzed at 400°C in nitrogen for 1 hour. A thickness of 3.3 μm was obtained for the coating. The coating has a tensile stress value of 6.333e dynes/$cm^2$.

## EXAMPLE 2

A 10cm (4") silicon wafer was spin coated at 1500 RPM for 20 seconds with Silvue® 101 (SDC Coatings, Inc., Anaheim, CA.; 31 wt% solids in methanol and isopropanol). Two coats of the resin solution were applied to the wafer, then the coated wafer was pyrolyzed at 400°C in oxygen for 1 hour. A thickness of 2.84 μm was obtained for the coating. The coating has a tensile stress value of 7.093e dynes/$cm^2$.

## EXAMPLE 3

The materials listed below were mixed in a container for four periods of twenty seconds with a sonic probe to prepare a solution useful as a coating composition.

| Amount | Component |
|---|---|
| 1.0 g | Aqueous alkanol dispersion of colloidal silica and partial condensate of methylsilanetriol |
| 15.0 g | Tungsten Carbide (WC) 0.83 μm average particle diameter |

(continued)

| Amount | Component |
|---|---|
| 3.0 g | Tungsten Metal (W) 0.6-0.9 μm average particle diameter |
| 0.08 g | $P_2O_5$ powder |
| 0.4 g | 3-glycidoxypropyltrimethoxysilane |
| 1.0 g | Isopropyl alcohol |
| 20.48 g | Total |

The resin component of this coating composition was a solution prepared generally according to the procedure set forth in Example 1 of U.S. Patent 3,986,997. This component contained 31 percent solids, 40 percent of which was $SiO_2$ and 60 percent partial condensate of $CH_3Si(OH)_3$. The remaining 69 percent of the resin component was a mixture containing water, acetic acid, isopropanol and n-butanol.

A 11.43 cm (4.5 inch) square alumina panel with a thickness of 1 mm (40 mils) was coated with the solution using a 0.05 mm (2 mil) drawdown bar. The coated alumina panel was allowed to air dry for 50 minutes. The coating was then pyrolyzed at 400°C for one hour in air. The coating was examined with a microscope under 1000x magnification and no cracks were observable. The thickness of the coating was 7.2 μm. The coating had a pencil hardness of 6H, a Vickers hardness of 633 $N/mm^2$ and a modulus of 23.6 GPa (i.e., giga or $10^9$ Pascals).

The pencil test used to measure the hardness of the coating is a standard qualitative method of determining scratch resistance of coatings. According to the test procedure, a coated panel is placed on a firm horizontal surface. A pencil is held firmly against the coated film at a 45° angle pointing away from the technician conducting the test. It is pushed away by the technician in 6.5 mm one-quarter inch strokes. The technician starts the process with the hardest lead pencil, i.e., 9H and continues down the scale of pencil hardness, i.e., 6B, to the pencil that will not cut into or gouge the film. The hardest pencil that will not cut through the film to the substrate for a distance of at least 3 mm (one-eighth of an inch) is recorded, using the Berol scale, i.e., Berol Corporation, Brentwood, Tennessee: 6B, 5B, 4B, 3B, 2B, B, HB, F, H, 2H, 3H, 4H, 5H, 6H, 7H, 8H, 9H

(softest) → (hardest)

The Vickers test used in our evaluation of the coating is a measure of the resistance of a material to deformation. The test procedure is described in the American Society for Testing and Materials, Philadelphia, Pennsylvania, (ASTM) Standard Number E92. According to the test procedure, a pyramidal diamond is used as an indenter. The test is conducted using a flat specimen on which the indenter is hydraulically loaded. When the prescribed number of indentations have been made, the specimen is removed, the diagonals of the indentations are measured using a calibrated microscope and then the values are averaged. A Vickers hardness number (VHN) can be calculated or the VHN can be taken from a precalculated table of indentation size versus Vickers Hardness Numbers. The Vickers scale for VHN ranges from a low value of 100 which is a measure of the softest, to a high value of 900 which is a measure of the hardest.

Coating compositions containing opaque materials which are most suitable for use according to our invention should contain 0.05-20 percent by weight of the combination of colloidal silica and partial condensate of methylsilanetriol, 5-30 percent by weight of tungsten metal, 30-80 percent by weight of tungsten carbide, 0.1-5 percent by weight of phosphoric anhydride and 1-5 percent by weight of a silane coupling agent; the remainder of the coating composition being the solvent(s).

The amount of tungsten carbide can be varied from 1-91 volume percent. The amount of tungsten metal can also be varied from 1-91 volume percent minus the volume percent of tungsten carbide. In addition, the amount of phosphoric anhydride can be varied from 1-30 volume percent, minus the combined volume percent of tungsten carbide and tungsten metal.

## Claims

**1.** A method of forming a ceramic coating on an electronic substrate comprising

applying onto an electronic substrate a coating composition comprising an aqueous alkanol dispersion of colloidal silica and partial condensate of $RSi(OH)_3$ where R is selected from an alkyl radical having from 1 to 3 carbon atoms, the vinyl radical, the 3,3,3-trifluoropropyl radical, the gamma-glycidoxypropyl radical and the

gamma-methacryloxypropyl radical with the proviso that at least 70% of the R radicals are methyl;
heating the coated electronic substrate at a temperature of 200 to 1000°C to convert the coating composition into ceramic coating.

2. The method as claimed in claim 1 wherein the coating composition additionally comprises 0.1 to 30 weight percent of a ceramic oxide precursor based on the weight of the coating composition wherein the ceramic oxide is selected from compounds containing (1) an element selected from aluminum, titanium, zirconium, tantalum, niobium, vanadium and boron; and (2) at least one hydrolyzable substituent selected from alkoxy and acyloxy.

3. The method as claimed in claim 1 or 2, wherein the coating composition additionally comprises a catalyst selected from platinum catalysts, rhodium catalysts and copper catalysts in an amount to provide 5 to 1,000 parts per million platinum, rhodium or copper based on the weight of the coating composition.

4. The method as claimed in any of claims 1 to 3, wherein the aqueous alkanol dispersion of colloidal silica and partial condensate of $RSi(OH)_3$ contains 10-50 weight percent solids, with the distribution being 10-70 weight percent colloidal silica and 30-90 weight percent of the partial condensate.

5. The method as claimed in any of claims 1 to 4, wherein the method additionally comprises applying a second coating selected from $SiO_2$ coatings, $SiO_2$/ceramic oxide layers, silicon-containing coatings, silicon carbon containing coatings, silicon nitrogen containing coatings, silicon oxygen nitrogen containing coatings, silicon nitrogen carbon containing coatings and diamond-like carbon coatings applied over the ceramic coating.

6. The method as claimed in any of claims 1 to 5, wherein the coating composition further comprises an opaque material carried in the aqueous alkanol dispersion of colloidal silica and partial condensate of methylsilanetriol and pyrolyzing the coating composition on the surface of the electronic device at a temperature in the range of 400 to 1,000°C, to convert the coating composition into a ceramic $SiO_2$ containing coating.

7. A method according to claim 6 wherein the coated surface of the electronic device is pyrolyzed at a temperature in the range of 400 to 800°C for one hour to less than 3 hours.

8. The method according to claim 6 or 7, wherein the coating composition further comprises a silane coupling agent to modify the surface of the opaque material for better adhesion, the silane coupling agent having the formula $A_{(4-n)}SiY_n$ where A is an alkyl group, an aryl group or a functional substituent selected from methacryl, methacryloxy, epoxy, vinyl and allyl; Y is a hydrolyzable radical selected from an alkoxy group with 1-6 carbon atoms, an alkoxyalkoxy group with 2-8 carbon atoms or an acetoxy group; and n is 1, 2 or 3.

9. A method according to claim 8 wherein the silane coupling agent is selected from 3-methacryloxypropyltrimethoxysilane, 3-glycidoxypropyltrimethoxysilane, 3-mercaptopropyltrimethoxysilane, vinyltriacetoxysilane, vinyltriethoxysilane, vinyl-tris(2-methoxyethoxy)silane and 2-(3,4-epoxycyclohexyl)ethyltrimethoxysilane.

10. A method according to any of claims 6 to 9, wherein the opaque material is tungsten carbide, tungsten metal, phosphoric anhydride and mixtures thereof.

11. A method according to claim 6 wherein a second coating of silicon carbide, diamond or silicon nitride, is applied over the ceramic coating by plasma enhanced chemical vapor deposition.

12. A coating composition for electronic devices comprising an opaque material carried in an aqueous alkanol dispersion of colloidal silica and partial condensate of methylsilanetriol, the coating composition having a pH of 3 to 6 wherein the opaque material, colloidal silica and partial condensate of methylsilanetriol comprise 0.5 to 80 weight percent of the coating composition.

13. A coating composition according to claim 12 further comprising a solvent selected from ketones, esters and glycol ethers.

14. A method of protecting an electronic device from damage due to exposure of the device to excited energy sources, radiation, light, abrasion and against wet etching techniques, comprising applying to a surface of the device the coating composition of claim 12 or 13.

15. A method according to claim 14, in which the coating composition is prepared by mixing the opaque material, aqueous alkanol dispersion of colloidal silica and partial condensate of methylsilanetriol, with a homogenizer, sonic probe or colloid mill.

**Patentansprüche**

1. Verfahren zur Ausbildung einer keramischen Beschichtung auf einem elektronischen Substrat, umfassend Auftragen einer Beschichtungszusammensetzung, die eine wässrige Alkanoldispersion aus kolloidalem Siliciumdioxid und partiellem Kondensat von $RSi(OH)_3$ enthält, wobei R ausgewählt ist aus Alkylresten mit 1 bis 3 Kohlenstoffatomen, dem Vinylrest, dem 3,3,3-Trifluorpropylrest, dem γ-Glycidoxypropylrest und dem γ-Methacryloxypropylrest, unter der Voraussetzung, dass mindestens 70% der R-Reste Methyl sind, auf ein elektronisches Substrat;
Erhitzen des beschichteten elektronischen Substrats auf eine Temperatur von 200-1000°C, um die Beschichtungszusammensetzung in eine keramische Beschichtung umzuwandeln.

2. Verfahren wie in Anspruch 1 beansprucht, wobei die Beschichtungszusammensetzung zusätzlich 0,1 bis 30 Gew.-%, bezogen auf das Gewicht der Beschichtungszusammensetzung, eines keramischen Oxidvorläufers enthält, wobei das keramische Oxid ausgewählt ist aus Verbindungen, die (1) ein Element, ausgewählt aus Aluminium, Titan, Zirkonium, Tantal, Niob, Vanadium und Bor, und (2) mindestens einen hydrolysierbaren Substituenten, ausgewählt aus Alkoxy und Acyloxy, enthalten.

3. Verfahren wie in Anspruch 1 oder 2 beansprucht, wobei die Beschichtungszusammensetzung zusätzlich einen Katalysator, ausgewählt aus Platinkatalysatoren, Rhodiumkatalysatoren und Kupferkatalysatoren, in einer Menge enthält, um 5 bis 1000 Teile pro Million Platin, Rhodium oder Kupfer, bezogen auf das Gewicht der Beschichtungszusammensetzung, bereit zustellen.

4. Verfahren wie in einem der Ansprüche 1 bis 3 beansprucht, wobei die wässrige Alkanoldispersion aus kolloidalem Siliciumdioxid und partiellem Kondensat von $RSi(OH)_3$ 10 bis 50 Gew.-% Feststoffe enthält, wobei die Verteilung 10 bis 70 Gew.-% kolloidales Siliciumdioxid und 30 bis 90 Gew.-% partielles Kondensat ist.

5. Verfahren wie in einem der Ansprüche 1 bis 4 beansprucht, wobei das Verfahren zusätzlich Auftragen einer zweiten Beschichtung, ausgewählt aus $SiO_2$-Beschichtungen, Schichten aus $SiO_2$/keramischem Oxid, siliciumhaltigen Beschichtungen, silicium-/kohlenstoffhaltigen Beschichtungen, silicium-/stickstoffhaltigen Beschichtungen, silicium-/sauerstoff-/stickstoffhaltigen Beschichtungen, silicium-/stickstoff-/kohlenstoffhaltigen Beschichtungen und diamantartigen Kohlenstoffbeschichtungen, umfasst, die über die keramische Beschichtung aufgetragen wird.

6. Verfahren wie in einem der Ansprüche 1 bis 5 beansprucht, wobei die Beschichtungszusammensetzung weiterhin einen opaken Stoff enthält, der in der wässrigen Alkanoldispersion von kolloidalem Siliciumdioxid und partiellem Kondensat von Methyl snantriol getragen wird, und die Beschichtungszusammensetzung an der Oberfläche des elektronischen Bauteils bei einer Temperatur im Bereich von 400-1000°C pyrolysiert wird, um die Beschichtungszusammensetzung in eine keramische $SiO_2$-haltige Beschichtung umzuwandeln.

7. Verfahren gemäss Anspruch 6, wobei die beschichtete Oberfläche des elektronischen Bauteils bei einer Temperatur im Bereich von 400-800°C für 1 bis weniger als 3 Stunden pyrolysiert wird.

8. Verfahren gemäss Anspruch 6 oder 7, wobei die Beschichtungszusammensetzung weiterhin ein Silankupplungsmittel enthält, um die Oberfläche des opaken Stoffs für eine bessere Haftung zu modifizieren, und das Silankupplungsmittel die Formel $A_{(4-n)}SiY_n$ aufweist, worin A eine Alkylgruppe, eine Arylgruppe oder ein funktioneller Substituent, ausgewählt aus Methacryl, Methacryloxy, Epoxy, Vinyl und Allyl ist, Y ein hydrolysierbarer Rest, ausgewählt aus einer Alkoxygruppe mit 1 bis 6 Kohlenstoffatomen, einer Alkoxyalkoxygruppe mit 2 bis 8 Kohlenstoffatomen oder einer Acetoxygruppe ist und n gleich 1, 2 oder 3 ist.

9. Verfahren gemäss Anspruch 8, wobei das Silankupplungsmittel ausgewählt ist aus 3-Methacryloxypropyltrimethoxysilan, 3-Glycidoxypropyltrimethoxysilan, 3-Mercaptopropyltrimethoxysilan, Vinyltriacetoxysilan, Vinyltriethoxysilan, Vinyl-tris(2-methoxyethoxy)silan und 2-(3,4-Epoxycyclohexyl)ethyltrimethoxysilan.

10. Verfahren gemäss einem der Ansprüche 6 bis 9, wobei der opake Stoff Wolframcarbid, Wolframmetall, Phosphorsäureanhydrid oder eine Mischung davon ist.

**11.** Verfahren gemäss Anspruch 6, wobei eine zweite Beschichtung aus Siliciumcarbid, Diamant oder Siliciumnitrid über die keramische Beschichtung mittels plasmaverstärktem chemischen Aufdampfen aufgetragen wird.

**12.** Beschichtungszusammensetzung für elektronische Bauteile, die einen opaken Stoff enthält, der in einer wässrigen Alkanoldispersion aus kolloidalem Siliciumdioxid und partiellem Kondensat von Methylsilantriol getragen wird, wobei die Beschichtungszusammensetzung einen pH-Wert von 3 bis 6 aufweist und der opake Stoff, das kolloidale Siliciumdioxid und das partielle Kondensat von Methylsilantriol 0,5 bis 80 Gew.-% der Beschichtungszusammensetzung ausmachen.

**13.** Beschichtungszusammensetzung gemäss Anspruch 12, die weiterhin ein Lösungsmittel enthält, das aus Ketonen, Estern und Glykolethern ausgewählt ist.

**14.** Verfahren zum Schutz eines elektronischen Bauteils vor Schäden durch Aussetzen des Bauteils an angeregte Energiequellen, Strahlung, Licht und Abrieb und gegen Nassätztechniken, umfassend Auftragen der Beschichtungszusammensetzung gemäss Anspruch 12 oder 13 auf eine Oberfläche des Bauteils.

**15.** Verfahren gemäss Anspruch 14, in dem die Beschichtungszusammensetzung durch Mischen des opaken Stoffs, der wässrigen Alkanoldispersion aus kolloidalem Siliciumdioxid und partiellem Kondensat von Methylsilantriol mit einem Homogenisator, einer Ultraschallsonde oder Kolloidmühle hergestellt wird.

## Revendications

**1.** Méthode de formation d'un revêtement céramique sur un substrat électronique, comprenant
l'application sur un substrat électronique d'une composition de revêtement constituée d'une dispersion dans un alcanol aqueux de silice colloïdale et de condensat partiel de $RSi(OH)_3$ où R est choisi parmi un radical alkyle ayant 1 à 3 atomes de carbone, le radical vinyle, le radical 3,3,3-trifluoropropyle, le radical gamma-glycidoxypropyle et le radical gammaméthacryloxypropyle, 70% au moins des radicaux R étant constitués de méthyle;
le chauffage du substrat électronique revêtu à une température de 200 à 1000°C, pour convertir la composition de revêtement en revêtement céramique.

**2.** Méthode selon la revendication 1, **caractérisée en ce que** la composition de revêtement comporte en outre 0,1 à 30% en poids d'un précurseur oxyde céramique sur la base du poids de la composition de revêtement, l'oxyde céramique étant choisi parmi des composés contenant (1) un élément choisi parmi l'aluminium, le titane, le zirconium, le tantale, le niobium, le vanadium et le bore ; et 2) au moins un substituant hydrolysable choisi parmi les groupes alkoxy et acyloxy.

**3.** Méthode selon l'une des revendications 1 ou 2, **caractérisée en ce que** la composition de revêtement comprend en outre un catalyseur choisi parmi les catalyseurs à base de platine, les catalyseurs à base de rhodium, les catalyseurs à base de cuivre dans des quantités correspondant à 5 à 1000 parties par million de platine, de rhodium ou de cuivre, sur la base du poids de la composition de revêtement.

**4.** Méthode selon l'une quelconque des revendications 1 à 3, **caractérisée en ce que** la dispersion dans un alcanol aqueux de silice colloïdale et de condensat partiel de $RSi(OH)_3$ contient 10-50% en poids de matières solides, la répartition étant de 10-70% en poids de silice colloïdale et 30-90% en poids de condensat partiel.

**5.** Méthode selon l'une quelconque des revendications 1 à 4, **caractérisée en ce que** la méthode comprend en outre l'application d'un second revêtement choisi parmi des revêtements de $SiO_2$, des couches de $SiO_2$/ oxyde de céramique, des revêtements contenant du silicium, des revêtements contenant du carbone et du silicium, des revêtements contenant de l'azote et du silicium, des revêtements contenant du silicium, de l'oxygène et de l'azote, des revêtements contenant du silicium, de l'azote et du carbone et des revêtements de carbone du type diamant appliqués sur le revêtement céramique.

**6.** Méthode selon l'une quelconque des revendications 1 à 5, **caractérisée en ce que** la composition de revêtement comporte en outre une matière opaque en suspension dans un alcanol aqueux de silice colloïdale et de condensat partiel de méthylsilanetriol et la pyrolyse de la composition de revêtement sur la surface de l'appareil électronique,

à une température située dans la plage de 400 à 1000°C, pour convertir la composition de revêtement en un revêtement contenant du $SiO_2$ céramique.

7. Méthode selon la revendication 6, **caractérisée en ce que** la surface revêtue de l'appareil électronique est pyrolysée à une température comprise entre 400 et 800°C pendant une période d'une heure à moins de trois heures.

8. Méthode selon l'une des revendications 6 ou 7, **caractérisée en ce que** la composition de revêtement comporte en outre un agent de couplage à base de silane pour modifier la surface de la matière opaque et assurer une meilleure adhérence, l'agent de couplage à base de silane ayant la formule $A_{(4-n)}$ $SiY_n$, dans laquelle A est un groupe alkyle, un groupe aryle ou un substituant fonctionnel choisi parmi les groupes méthacryle, méthacryloxy, époxy, vinyle et allyle ; Y est un radical hydrolysable choisi parmi un groupe alkoxy de 1 à 6 atomes de carbone, un groupe alkoxyalkoxy de 2 à 8 atomes de carbone ou un groupe acétoxy ; et n est 1, 2, ou 3.

9. Méthode selon la revendication 8, **caractérisée en ce que** l'agent de couplage à base de silane est choisi parmi le 3-méthacryloxypropyltriméthoxysilane, le 3-glycidoxypropyltriméthoxysilane, le 3-mercaptopropyltriméthoxysilane, le vinyltriacétoxysilane, le vinyltriéthoxysilane, le vinyl-tris (2-méthoxyéthoxy) silane et le 2-(3,4-époxycyclohexyl) éthyltriméthoxysilane.

10. Méthode selon l'une quelconque des revendications 6 à 9, **caractérisée en ce que** la matière opaque est du carbure de tungstène, du tungstène métal, de l'anhydride phosphorique et leurs mélanges.

11. Méthode selon la revendication 6, **caractérisée en ce qu'**un deuxième revêtement de carbure de silicium, de diamant ou de nitrure de silicium est appliqué sur le revêtement céramique par dépôt chimique en phase vapeur activé par un plasma.

12. Composition de revêtement pour appareils électroniques, comprenant une matière opaque en suspension dans une dispersion dans un alcanol aqueux de silice colloïdale et de condensat partiel de méthylsilanetriol, la composition de revêtement ayant un pH de 3 à 6, **caractérisée en ce que** la matière opaque, la silice colloïdale et le condensat partiel de méthylsilanetriol représentent 0,5 à 80% en poids de la composition de revêtement.

13. Composition de revêtement selon la revendication 12, comprenant, en outre, un solvant choisi parmi des cétones, des esters et des éthers de glycol.

14. Méthode de protection d'un dispositif électronique contre les dommages dus à l'exposition de l'appareil à des sources d'énergie excitées, des rayonnements, la lumière, l'abrasion et contre les techniques d'attaque humide, comprenant l'application sur une surface du dispositif de la composition de revêtement de la revendication 12 ou 13.

15. Méthode selon la revendication 14, selon laquelle la composition de revêtement est préparée par mélange de la matière opaque, de la dispersion dans un alcanol aqueux de silice colloïdale et de condensat partiel de méthylsilanetriol, avec un homogénéiseur, une sonde sonique ou un moulin à colloïdes.